# EUROPEAN PATENT APPLICATION

(11) **EP 4 538 793 A1**
(43) Date of publication of application: **16.04.2025**
(21) Application number: 23202984.3
(22) Date of filing: 11.10.2023
(51) Int. Cl.: G03F 7/00

(54) **METHOD FOR DESIGNING A FOCUS TARGET FOR FOCUS METROLOGY**

(71) Applicant: ASML Netherlands B.V., 5500 AH Veldhoven (NL)
(72) Inventor: FU, Jiyou, San Jose, 95134 (US); ZHAO, Wangshi, San Jose, 95134 (US); WHYSONG, David, Harold, San Jose, 95134 (US); ZHANG, Chenji, San Jose, 95134 (US); BAI, Shufeng, San Jose, 95134 (US); LI, Pengcheng, San Jose, 95134 (US)
(74) Representative: ASML Netherlands B.V.

(57) **Abstract**

Disclosed is a method for designing a focus target for determining a focus setting of a lithographic apparatus used to form said target. The method comprises determining an initial target design, the initial target design being configure to enhance a mask 3D effect, resultant from the effect of three dimensional reticle features and an off-axis beam incidence on a reticle comprising target features arranged in accordance to said target design; modeling an exposure a target according to said initial target design and measurement of said target for at least a plurality of different focus settings; varying the target design based on said modeling so as to improve said target design in terms of at least one performance indicator; and determining a final target design based on said at least one performance indicator.

## Description

### FIELD

The present invention relates to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure and scatterometry based tools for inspecting/measuring the exposed and/or etched product in process control; e.g., to measure overlay.

One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature. Traditionally, optimal settings were determined by "send-ahead wafers" i.e. substrates that are exposed, developed and measured in advance of a production run. In the send-ahead wafers, test structures are exposed in a so-called focus-energy matrix (FEM) and the best focus and energy settings are determined from examination of those test structures.

Another method of determining focus and/or dose has been through diffraction based focus techniques. Diffraction based focus may use target forming features on the reticle which print targets having a degree of asymmetry which is dependent on the focus and/or dose setting during printing. This degree of asymmetry can then be measured and the focus and/or dose inferred from the asymmetry measurement. Such focus measuring methods, and the associated test structure designs have a number of drawbacks. Many test structures require subresolution features or grating structures with large pitches. Such structures may contravene design rules of the users of lithographic apparatuses. Focus measuring techniques may comprise measuring asymmetry in opposite higher (e.g., first) order radiation scattered by special, focus dependent, target structures and determining focus from this asymmetry.

It would be desirable to improve on present focus metrology techniques, particularly in the context of EUV lithography.

### SUMMARY

In a first aspect of the invention there is provided a method for designing a focus target for determining a focus setting of a lithographic apparatus used to form said target, the method comprising: determining an initial target design, the initial target design being configure to enhance a mask 3D effect, resultant from the effect of three dimensional reticle features and an off-axis beam incidence on a reticle comprising target features arranged in accordance to said target design; modeling an exposure a target according to said initial target design and measurement of said target for at least a plurality of different focus settings; varying the target design based on said modeling so as to improve said target design in terms of at least one performance indicator; and determining a final target design based on said at least one performance indicator.

In a second aspect of the invention there is provided a method for designing a focus target for determining a focus setting of a lithographic apparatus used to form said target, the method comprising: modeling an exposure a target according to a target design and measurement of said target for at least a plurality of different focus settings; applying optical proximity correction on the target design to only substantially enhance a dose process window of the target design, and not to substantially enhance a focus process window; varying the target design based on said modeling so as to improve said target design in terms of at least one performance indicator; and determining a final target design based on said at least one performance indicator.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic overview of a lithographic cell;
- Figure 3 depicts a schematic representation of holistic lithography, representing a cooperation between three key technologies to optimize semiconductor manufacturing;
- Figure 4(a) is a flow diagram describing a metrology target design method;
- Figure 4(b) is a flow diagram describing different visualization components of a target designer;
- Figure 5(a) illustrates the mask 3D effect on vertical reticle features;
- Figure 5(b) illustrates the mask 3D effect on horizontal reticle features;
- Figures 6(a), 6(b), 6(c) and 6(d) are schematic representations of initial asymmetric focus target designs according to an embodiment of the invention;
- Figures 7(a), 7(b), 7(c), 7(d), 7(e) and 7(f) are schematic representations of initial symmetric focus target designs according to an embodiment of the invention; and
- Figure 8 is a flow diagram of a focus target design method according to an embodiment.

### DETAILED DESCRIPTION

Before describing embodiments of the invention in detail, it is instructive to present an example environment in which embodiments of the present invention may be implemented.

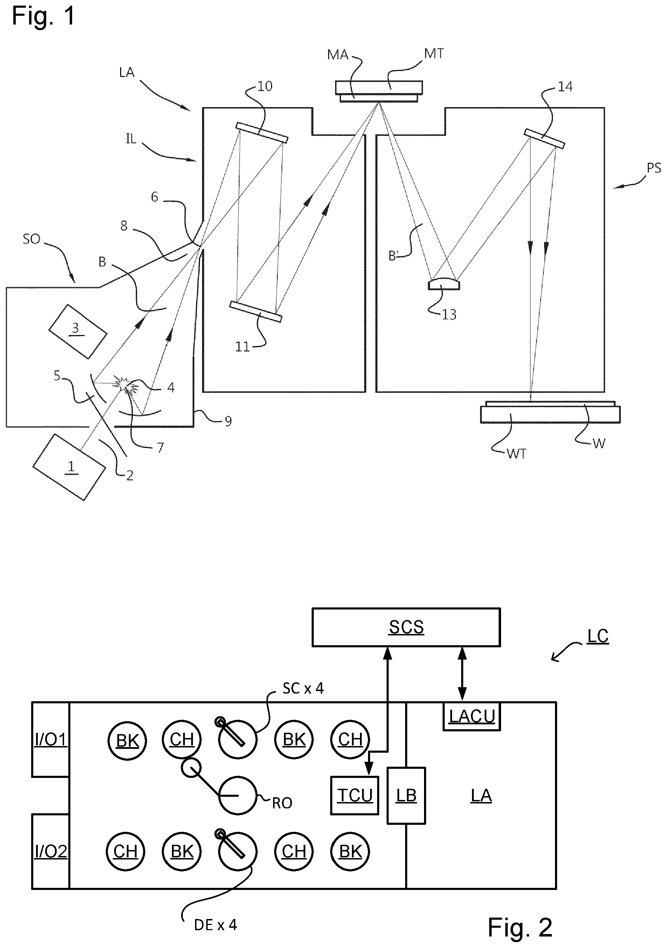

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that may be smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source, high harmonic generation (HHG) source or a free electron laser (FEL) may be used to generate EUV radiation.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

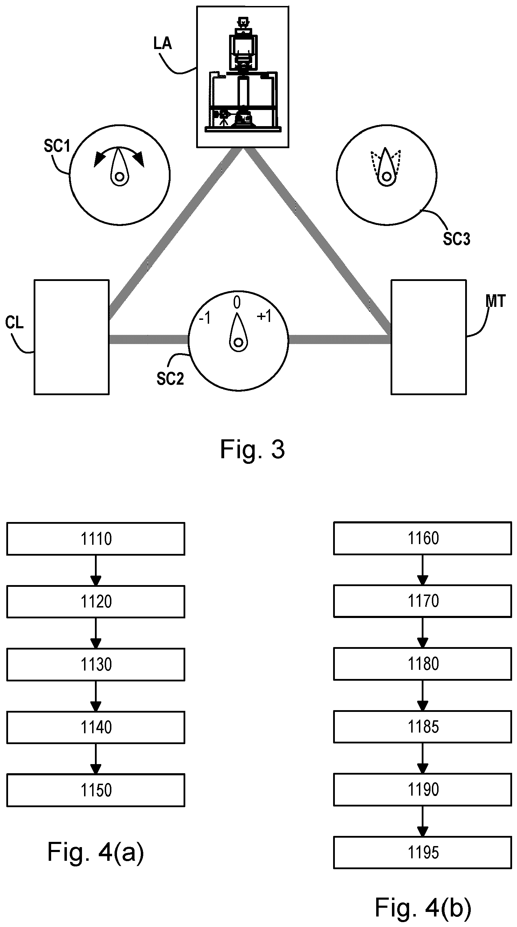

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

When monitoring a lithographic process, it is desirable to monitor a lithographic process parameter such as focus of the lithography beam on the substrate. One known method of determining the focus setting from a printed structure is by micro-diffraction based focus (µDBF). Micro-diffraction based focus may use target forming features on the reticle which print targets having a degree of asymmetry which is dependent on the focus setting during printing. This degree of asymmetry can then be measured using a scatterometry based inspection method, for example by measuring the intensity asymmetry between the intensities of +1st and -1st order radiation diffracted from the target, to obtain a measure of the focus setting. The focus-dependent asymmetry may be achieved by providing "sub-resolution features" (also known as sub-resolution assist features), which are below the resolution limit of the lithographic apparatus being used to expose the target. Because these sub-resolution features are below this resolution limit, they are not actually formed on the substrate, instead they affect the formation of other (larger) adjacent features which are resolved. In particular, by placing these sub-resolution features along only one wall of the larger feature, the wall formation (e.g., the side wall angle) of this wall will depend on focus. In this way, the symmetry (or asymmetry) of the larger feature will be focus dependent.

This µDBF approach is generally effective for DUV focus monitoring. However, with EUV lithographic apparatuses, the resolution of the lithographic apparatus is greater such that the smaller features (e.g., assist features) of the target are resolved, weakening the signal from such a target. Also, EUV lithography uses thinner resists which also means that the signal is typically weaker for EUV µDBF than for DUV µDBF. To address the signal strength issue, an alternative EUV focus metrology technique, hereafter referred to as feature bias focus metrology, may use a target comprising a pair of focus sub-targets, where each sub-target has the well-known Bossung curve relationship with focus, i.e., comprising a respective Bossung curve which peaks at best focus, and where each of the sub-targets may be formed with respective different best focus values and partially overlapping Bossung curves. Optionally, each of the Bossung curve relationships may be the same, other than the best focus offset. It can be appreciated that the concepts disclosed herein may be applied to either of these target type and EUV metrology techniques (or more generally any metrology technique which uses off-axis radiation onto the mask/reticle).

This latter metrology technique may use a target comprising at least a first sub-target and a second sub-target which have been formed with a best focus offset df between the two sub-targets. The focus response with a measurement value for a sub-target parameter may take the form of a Bossung curve for each of the first and second sub-targets. Focus is a function of a first measurement value of a sub-target parameter obtained from measurement of the first sub-target and a second measurement value of a sub-target parameter obtained from measurement of the second sub-target. Therefore, it is proposed that measured values of a parameter from the first and second sub-targets be obtained and a value for focus derived from these measured values. The parameter may be an intensity parameter, e.g., an intensity of at least one diffraction order (e.g., the zeroth order and/or one or more first diffraction orders). The monotonic relationship may be obtained through a comparison (e.g., a difference) of the measured value(s) from the first sub-target and the measured value(s) from a second sub-target (optionally divided by an average measurement value over the two sub-targets).

In an embodiment, the best focus offset may be obtained via induced astigmatism, e.g., using astigmatism based focus (ABF) techniques, wherein an astigmatism may be induced in the imaging lens and/or reticle. ABF is described in US2016363871A1, which is incorporated herein by reference. Inducing astigmatism may be non-ideal as it cannot be used for production monitoring. Therefore other methods may be used to obtain a suitable best focus offset, e.g., in terms of differences in target parameters between the first sub-target and second sub-target.

In order to improve EUV layer focus performance, one approach may comprise printing a large number (e.g., hundreds or thousands) of focus targets on the EUV wafer and measuring all of them to find the best performance target. This brute-force method does not always guarantee that a good focus target design will be found, and is time consuming and costly. Another approach may be optimize current DUV target designs for each EUV layer. This however can be very slow and again is not guaranteed to provide a satisfactory target.

A metrology target design platform (MTDP) may be used in designing the focus targets according to embodiments disclosed herein. Such a metrology target design platform is described in detail in WO2016078861A1, which is incorporated herein by reference. MTDP enables a user to be able to perform all required steps to design metrology targets without intervention from the creator of the MTDP program. Appropriate graphic user interfaces (GUI) are made available to set up, execute, review and use the features of the MTDP program. Usually, no special interface with the fabrication tools is needed because the metrology target design is mostly confined in the simulation domain rather than in the actual device manufacturing domain.

Conventional target design tools, such as multi-physics 3-D modeling software, usually "draw" or "build" a geometric structure using area or volume elements which are purely graphical. Those graphical elements are assigned multi-physics parametric characteristics. When using an MTDP method, the lithography process itself drives the rendering of the 3D structure of the metrology targets, so the designers do not have to build the model element-by-element.

Figure 4(a) shows a flowchart that lists the main stages in an MTDP method. In stage 1110, the materials to be used in the lithography process are selected. The materials may be selected from a materials library interfaced with the MTDP through an appropriate GUI. In stage 1120, a lithography process is defined by entering each of the process steps and building a computer simulation model for the entire process sequence. In stage 1130, a metrology target is defined, i.e., dimensions and other characteristics of various features included in the target are entered into the MTPD program. For example, if a grating is included in a structure, then the number of grating elements, width of individual grating elements, spacing between two grating elements etc. may be defined. In stage 1140, the 3D geometry is created. This step also considers if there is any information relevant to a multi-layer target design, for example, the relative shifts between different layers. This feature may enable multi-layer target design. In stage 1150, the final geometry of the designed target is visualized. Not only the final design may be visualized, but as the designer applies various steps of the lithography process, they may visualize how the 3D geometry is being formed and changed because of process-induced effects. For example, the 3D geometry after resist patterning is different from the 3D geometry after resist removal and etching.

The target designer may be enabled to visualize the stages of the method to facilitate their perception and control during modelling and simulation. Different visualization tools, referred to as "viewers," are built into the MTDP software. For example, as shown in Figure 4(b) a designer can view material plots 1160 (and may also get a run time estimation plot) depending on the defined lithography process and target. Once the lithography model is created, the designer may view the model parameters through model viewer tool 1170. Design layout viewer tool 1180 may be used to view the design layout (e.g., visual rendering of the GDS file). Resist profile viewer tool 1185 may be used to view pattern profiles in a resist. Geometry viewer tool 1190 may be used to view 3D structures on a wafer. A pupil viewer tool 1195 may be used to view simulated response on a metrology tool.

More detail on such a metrology target design platform can be found in the aforementioned WO2016078861A1.

In order to improve focus target design for EUV focus targets, e.g., to design a target in a reasonable time and for reasonable cost, it is proposed to take advantage of the known EUV mask 3D effect. For example, focus target design may begin with a target which increases or maximizes the EUV mask 3D effect. In particular, the focus target design may begin with an initial target which increases or maximizes a shadowing mask 3D effect, resultant from the effect of three dimensional reticle features and off-axis beam incidence on the reticle. It is well known that EUV lithography requires reflective optics and that to avoid overlap of incident and reflected radiation, the EUV lithography process uses a non-normal or off-axis illumination. That is, the chief ray angle of the EUV radiation beam, (i.e., the angle between the optical axis of the illumination system and the normal of the patterning device surface) is non-zero. More specifically, the chief ray angle in EUV lithography may be greater than 5° (e.g., 6°).

The off-axis illumination of the mask causes one or more of: asymmetric shadowing, a size bias between features with different orientations and telecentricity errors. The image contrast varies with the feature orientation and can easily drop far below intuitively expected values. The deformation of the wavefront or phase of the incident light by thick absorbers generates aberration-like effects, especially variations of the best-focus (BF) position vs. the pitch and size of the imaged patterns. Partial reflection of light from the top of the absorber generates a weak secondary image, which superposes with the main image. Each of these may be described as a "mask 3D effect", alone or in any combination, within the context of this disclosure.

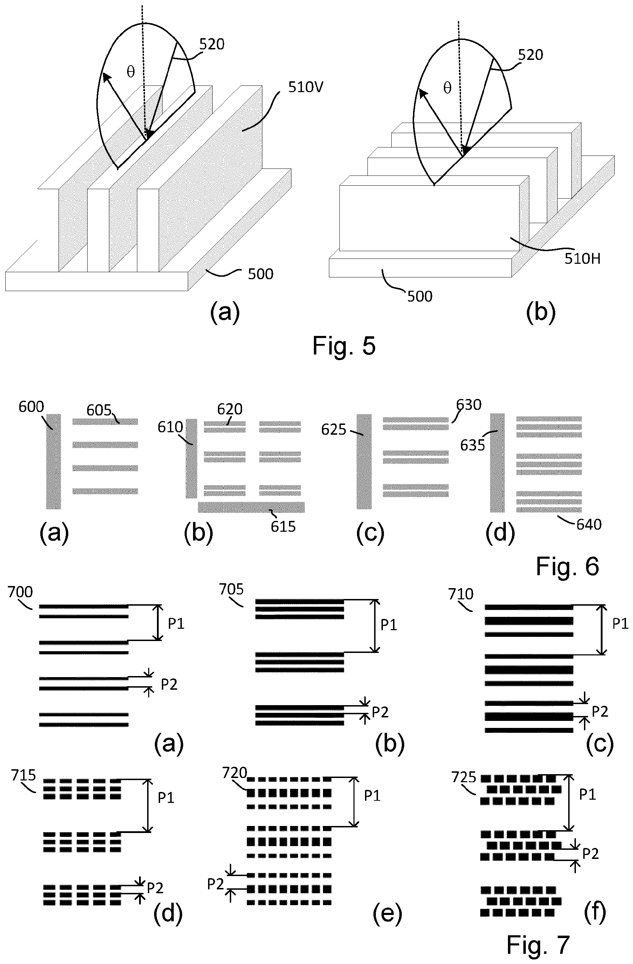

Figure 5 illustrates how the mask 3D effect may be sensitive to different feature arrangements on a mask. For example, mask 3D effects may be orientation dependent. In particular, mask 3D effects related to horizontal features may be more pronounced when compared to vertical features; i.e., features extending along a direction perpendicular to an illumination incidence plane on said reticle, said illumination incidence plane comprising a plane in which the illumination beam is incident on the reticle. Figure 5(a) illustrates a mask 500 comprising vertical features 510V. The illumination 520 has off-axis incidence on the mask, e.g., having a chief ray angle of 6°. As such, the illumination incidence plane and feature direction are co-parallel. In Figure 5(b), the mask 500 comprises horizontal features 510H (perpendicular to the illumination incidence plane). Because of this and the off-axis incidence on the mask, there will be a shadowing due to the features 510H.

This shadowing means that horizontal line features may be more sensitive to EUV scanner focus than vertical line features. As such, a proposed method may comprise beginning with a target with many horizontal features. For example, the initial target design may comprise a large number of horizontal features and/or a large percentage of the target features and/or target feature area comprising horizontal features. The horizontal features in this case may include one or both of metrology tool optical-pitch features and metrology tool below optical-pitch features.

Metrology tool optical-pitch features may comprise features having a CD and/or forming a periodic structure having a pitch detectable using a metrology tool such as a scatterometer. In an embodiment, a plurality of metrology tool optical-pitch features may be arranged to form a periodic structure or grating with a (metrology tool) optically detectable pitch. In this context, an optically detectable pitch, detectable by a metrology tool, may comprise having at least a pitch of the order of magnitude 100nm; e.g., of 300nm or greater, 400nm or greater or 500nm or greater.

The metrology tool below optical-pitch features may comprise features such as assist features or segmentation features which have a CD and/or or form a periodic structure having a pitch below what is detectable by the metrology tool, e.g., due to the typically visible wavelength(s) used in such a metrology tool. In an embodiment, a plurality of metrology tool below optical-pitch features may be also arranged to form a below optical-pitch periodic structure, e.g., within each metrology tool optical-pitch feature. The below optical-pitch of such a below optical-pitch periodic structure, and/or the CD of each said below optical-pitch feature may be less than 200nm, less than 100nm, 80nm, less than 60nm or less than 50nm for example. As such the less than optical-pitch and/or the CD of less than optical-pitch features may be similar to a device CD and/or device pitch (i.e., the CD or device pitch of the product structure).

In an embodiment, the percentage of the target features comprised within the initial target which are horizontal features and/or the percentage of the total initial target feature area comprising horizontal features may be more than 50%, more than 60%, more than 70%, more than 80%, more than 90%, more than 95% or more than 99% for example. In this context, horizontal features may be continuous or may be broken (e.g., comprise one or more gaps), e.g., where very long continuous features are not permitted within design rules.

To effectively collect zero and high order signal of the focus target by the optical metrology tool, it may be preferred that metrology tool optical-pitch features comprise dense lines rather than isolated lines as these show greater focus sensitivity. Dense lines in this context may comprise, for example, having a line-space ratio denser than 1:3, denser than 1:2 or denser or equal to 1:1. Alternatively or in combination, a larger feature pitch to (optical tool measurement) wavelength ratio for the metrology tool optical-pitch features may be preferred as this results in greater focus sensitivity. A large feature pitch to wavelength ratio in this context may comprise, for example a ratio greater than 1.05 (e.g., 105:100).

The initial target design may comprise metrology tool below optical-pitch features (e.g., device pitch like features), such as assist features and/or segmentation features, and arranged to meet the optical-pitch layout. For example, the initial target may comprise two or more asymmetric target features, each asymmetric target feature comprising a combination of at least one metrology tool optical-pitch feature with at least one metrology tool below optical-pitch feature to form an asymmetric target feature. Each such feature may comprise e.g., a "comb" structure, with the metrology tool metrology tool below optical-pitch features each extending (e.g., perpendicularly) from one side of a metrology tool optical-pitch feature. Optionally, a second metrology tool optical-pitch feature may be provided per asymmetric target feature, e.g., an x-aligned feature and a y-aligned feature. The initial target may comprise isolated metrology tool below optical-pitch features (or isolated sets of metrology tool below optical-pitch features, where each set comprises 2 or more device like features) as isolated sets of metrology tool below optical-pitch features show better focus sensitivity. The line-space ratio between isolated metrology tool below optical-pitch features or isolated sets of metrology tool below optical-pitch features may be less dense than 1:1 (e.g., a line-space ratio having a space wider than the line width), less dense than 1:2 (e.g., a line-space ratio having a space wider than twice the line width), less dense than 1:3 or less than dense than or equal to 1:4. In the case of isolated sets of metrology tool below optical-pitch features, each set of e.g., 2 or 3 device pitch like features may have a line-space ratio greater than 2:3 (e.g., 1:1), but such that the space between each set is greater than 1, 2 or 3 or more times the total width of the set.

In an embodiment, the metrology tool optical-pitch features may each have a small CD (width). In an embodiment, the metrology tool below optical-pitch features may be arranged with a small pitch (or pitches). For example, a greater number of metrology tool below optical-pitch features having narrow (e.g., horizontal) lines has better focus sensitivity than a smaller number of wider (e.g., horizontal) lines. In this context, a small CD or linewidth may be smaller than 50nm, smaller than 46nm, smaller than 42nm, smaller than 38nm, smaller than 34nm, smaller than 30nm, smaller than 28nm, smaller than 26nm, smaller than 24nm, smaller than 22nm, smaller than 20nm, smaller than 18nm, smaller than 16nm or smaller than 14nm. In this context, a small pitch may be smaller than 100nm, smaller than 92nm, smaller than 84nm, smaller than 76nm, smaller than 68nm, smaller than 60nm, smaller than 56nm, smaller than 52nm, smaller than 48nm, smaller than 44nm, smaller than 40nm, smaller than 36nm, smaller than 32nm or smaller than 28nm.

The length of the metrology tool below optical-pitch features may be significantly longer than the width of the metrology tool resolvable feature (e.g., more than 3 times greater, more than 4 times greater, more than 5 times greater, more than 6 times greater, e.g., where, for example, the metrology tool optical-pitch feature is vertical and the metrology tool below optical-pitch features are horizontal.

Figure 6 illustrates four, purely exemplary, asymmetric target features of which a focus target (or initial target) may comprise multiple repetitions. Figure 6(a) shows an asymmetric target feature comprising a metrology tool optical-pitch feature 600, and multiple (isolated) metrology tool below optical-pitch features 605 along one side of the metrology tool optical-pitch feature 600. Figure 6(b) shows an asymmetric target feature comprising a first metrology tool optical-pitch feature 610 and second metrology tool optical-pitch feature 615 arranged mutually perpendicularly, and multiple metrology tool below optical-pitch features 620 along one side of the first metrology tool optical-pitch feature 610. In this example, the multiple metrology tool below optical-pitch features 620 are broken (this may be the case with any of the other examples). Figure 6(c) shows an asymmetric target feature comprising a metrology tool optical-pitch feature 625, and multiple (isolated) sets 630 of metrology tool below optical-pitch features along one side of the metrology tool optical-pitch feature 600. Here each set comprises two metrology tool below optical-pitch features. Figure 6(d) shows an asymmetric target feature comprising a metrology tool optical-pitch feature 635, and multiple (isolated) sets 640 of metrology tool below optical-pitch features along one side of the metrology tool optical-pitch feature 600. Here each set comprises three metrology tool below optical-pitch features.

It can be appreciated that these are only example arrangements. It may also be appreciated that focus targets may comprise only symmetrical features (e.g., at least one, and preferably at least two substantially symmetric metrology gratings). Such focus target arrangements may comprise feature bias metrology targets (e.g., sub-target pairs with best focus offset between them).

Figures 7(a)-7(f) illustrate a number of different example focus target designs which are made up of symmetrical features. In each case the metrology tool optical-pitch is designated P1 and the metrology tool below optical-pitch (e.g., segmentation pitch) is designated P2. Figures 7(a) to 7(c) show targets for which metrology tool optical-pitch features 700, 705, 710 are unbroken horizontally (e.g., comprise continuous horizontal lines). Each of the metrology tool optical-pitch features 700, 705, 710 are segmented vertically. In Figure 7(a) each metrology tool optical-pitch feature 700 comprises two metrology tool below optical-pitch features, e.g., two lines of substantially equal CD. In Figure 7(b) each metrology tool optical-pitch feature 705 comprises three metrology tool below optical-pitch features, e.g., three lines of substantially equal CD. In Figure 7(c) each metrology tool optical-pitch feature 710 comprises three metrology tool below optical-pitch features, e.g., three lines of which the middle line has a different CD to the other two lines.

In Figures 7(d)-7(f), the metrology tool optical-pitch features 715, 720, 725 are broken horizontally (e.g., comprise broken horizontal lines). In Figure 7(d) each metrology tool optical-pitch feature 715 comprises three broken metrology tool below optical-pitch features, e.g., three broken lines of substantially equal CD (e.g., it is a broken line equivalent of the target of Figure 7(b)). In Figure 7(e) each metrology tool optical-pitch feature 720 comprises three broken metrology tool below optical-pitch features, e.g., three lines of which the middle line has a different CD to the other two lines (e.g., it is a broken line equivalent of the target of Figure 7(c)). In Figure 7(f) each metrology tool optical-pitch feature 7250 comprises three metrology tool below optical-pitch features, e.g., three broken lines of substantially equal CD, where the middle line is horizontally offset with respect to the other two lines.

It can be appreciated that these are only examples, and features can be combined from any of the Figure 7 examples (e.g., one of the lines may be offset in any of the examples of Figures 7(a) to 7(e). It can be further appreciated that a full target may comprise two or more different examples of these, e.g., such that they have a respective different best focus.

The focus target may comprise mirrored sub-targets. Where this is the case, a more linear relationship between measurement and focus may be obtained by combining the measured values of the mirrored sub-targets compared to a value from a single target.

The focus target may comprise sub-targets aligned in x and y directions.

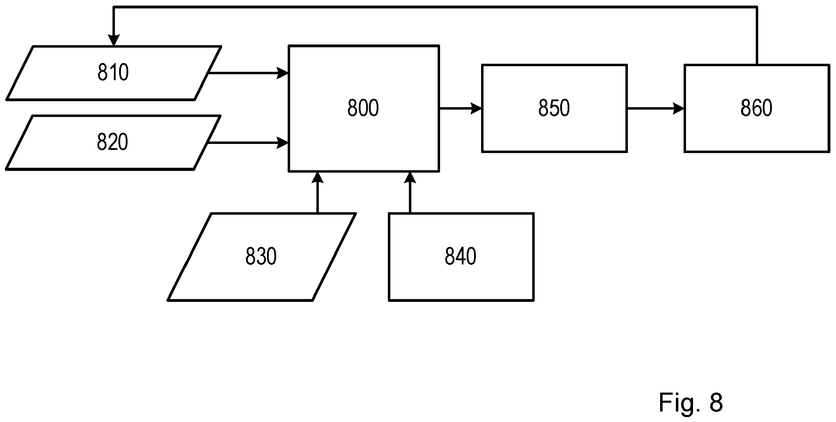

Figure 8 is a flow diagram illustrating a possible framework for designing a focus target beginning with an initial target, optionally configured for high focus sensitivity due to EUV mask 3D effect, and more particularly asymmetrical EUV mask 3D effect (e.g., shadowing effect) resulting from non-normal incidence on the reticle. The method may use a metrology target design platform (MTDP) 800 as has been described. The MTDP 800 may comprise a computational lithography module which is able to simulate the lithography process of transferring the patterning device pattern onto a resist layer of a substrate at various scanner focus and/or scanner dose settings as well as the yielded pattern in that resist layer after development of the resist. The MTDP 800 may comprise a computational metrology module able to simulate metrology operations such as simulating focus (and/or dose) metrology using a scatterometer.

The MTDP 800 receives target settings 810, e.g., describing the initial target layout and other design settings such as the stack settings. MTDP 800 also receives scanner settings 820 including focus. Other scanner setting may comprise e.g., dose and aberration settings. Also inputted into MTDP 800 is metrology tool settings 830 and an EUV scanner and resist model 840. The MTDP can model imaging performance of the target e.g., through focus or focus and dose combinations, and corresponding metrology signals for measuring the target for each focus value/focus and dose combination. In this way, the metrology signal response to focus may be modelled, analysed and assessed 850 for the initial target layout. The assessment may determine one or more performance indicators such as sensitivity of the metrology signal with focus. Other performance indicators may comprise metrology signal strength, monotonicity and/or linearity of the metrology signal sensitivity with focus, metrology signal range with respect to focus range, focus-dose crosstalk (e.g., over a focus range of interest).

Optionally, to further improve focus sensitivity of the target, EUV (e.g., Zernike and/or Tatian) aberration terms may be included into the MTDP 800, such that step 850 includes an assessment of target focus signal sensitivity to the aberration (e.g., Zernike and/or Tatian) terms. In such an embodiment, a performance indicator may be sensitivity to focus with respect to sensitivity to non-focus aberration terms. For example, a preferred target may be one which has high sensitivity to one or more focus Zernike and/or Tatian terms, and significantly lower (minimal) sensitivity to one or more non-focus Zernike and/or Tatian terms.

At step 860, a new or updated target design may be determined based on the assessment of step 850. The updated target design may be determined to improve focus sensitivity and optionally any of the other performance indicators. This updated target may then be used in updated target settings 810 as an input for the MTDP 800 in a further iteration of the method. Iterations may be repeated until convergence on a final target design (e.g., one that meets at least one threshold value for at least one of said one or more performance indicators).

It can be appreciated that the final target design may comprise any of the parameter values or ranges as is disclosed above in the context of the initial target design. The concepts disclosed herein may also relate to a reticle and/or substrate comprising the final target design (e.g., a target design comprising any of the features and parameter values described above).

It can be appreciated that the EUV mask 3D effect based focus target design disclosed herein is applicable to any EUV lithography including "low NA" EUV (e.g., 0.33NA), "high NA" EUV (e.g., 0.55NA) and "Hyper-NA" EUV (e.g., 0.75NA) lithography. It is also applicable to non-EUV application should the lithographic apparatus use non normal incidence onto 3D reticle features (e.g., reflective reticle).

Applying optical proximity correction (OPC) on the assist features during mask design may help to achieve higher focus sensitivity. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern (e.g., OPC) together with one or more features of the illumination. The optimizations may use the parameterized model described herein to predict values of various parameters (including images, etc.), for example.

In some embodiments, OPC is a photolithography enhancement technique used to compensate for image errors due to diffraction or process effects. The OPC process configures features of a pattern to correct errors (e.g., irregularities such as line widths that are narrower or wider than designed, distortions such as rounded comers, etc.) caused due to the limitations of light. For example, the OPC process may move edges or add extra polygons to the pattern written on the mask. OPC may be implemented in various ways, e.g., using rule based OPC which is be driven by pre-computed look-up tables based on width and spacing between features, or using simulation models that dynamically simulate the final pattern for a given mask pattern. The objective is to reproduce on the semiconductor wafer, as well as possible, the original layout drawn by the designer.

To further enhance the focus sensitivity, an amended OPC method may be employed on the focus targets which significantly or substantially enhances the dose process window of the target only (i.e., amends the target features on the reticle such that the target will be properly formed on a substrate over a dose range of interest described by the dose process window, e.g., around a best dose value), in contrast to traditional OPC methods which enhance both the dose and focus process window together such that the target will be properly formed over both a focus range of interest and a dose range of interest.

In such an embodiment, the process window conditions may comprise a fixed or nominal focus condition. Alternatively, the amended OPC may be applied through-focus. The dose range of interest may be, within 3% of a best dose value, within 4% of a best dose value, within 5% of a best dose value, within 6% of a best dose value, within 7% of a best dose value, within 8% of a best dose value, within 9% of a best dose value or within 10% of a best dose value (e.g., in the latter case the dose range of interest may be between -10% to +10% of the best dose value). In an embodiment, the enhancement of the dose window and/or dose range of interest may increase the dose window and/or dose range of interest substantially, e.g., by 2%, by 3% by 4%, by 5%, by 8%, by 10%, by 12%, by 14% or by 16% for example.

If there is focus offset for the specific process, the focus condition can be at this specific focus offset. The optimization criteria may be any suitable criteria depending on the specific process. For example, the optimization criteria may be a minimum CD and/or space for a target feature (e.g., the minimum CD and/or space is 10nm, 12nm, 13nm or 14nm for example. Of course, the optimization criteria can be more complex than this; e.g. it can specify limits on one or more of a feature position shift, or feature CD (or space) change.

The amended OPC method may be such that the focus process window is not substantially increased, e.g,. it increases by no more than 4%. no more than 3%, no more than 2%, no more than 1%, no more than 0.5%, no more than 0.3% or no more than 0.1% for example. As such, not substantially enhancing the focus process window may comprise a small enhancement of the focus process window.

An advantage of this amended OPC method is low dose crosstalk for the focus target and good printability for the focus sensitive pattern. It can be appreciated that the dose process window after this amended OPC has been applied will comprise a much larger than typical dose process window and the focus process window will be smaller than typical focus process window.

In some embodiments, an optimization process of a system may be represented as a cost function. The optimization process may comprise finding a set of parameters (design variables, process variables, inspection operation variables, etc.) of the system that minimizes the cost function. The term "design variables" as used herein comprises a set of parameters of a lithographic projection apparatus or a lithographic process, for example, parameters a user of the lithographic projection apparatus can adjust, or image characteristics a user can adjust by adjusting those parameters. It should be appreciated that any characteristics of a lithographic projection process, including those of the source, the patterning device, the projection optics, or resist characteristics can be among the design variables in the optimization. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function may often be a non-linear function of the design variables. Then standard optimization techniques may be used to minimize the cost function.

Further embodiments are disclosed in the subsequent numbered clauses:
1. A method for designing a focus target for determining a focus setting of a lithographic apparatus used to form said target, the method comprising:
   determining an initial target design, the initial target design being configure to enhance a mask 3D effect, resultant from the effect of three dimensional reticle features and an off-axis beam incidence on a reticle comprising target features arranged in accordance to said target design;
   modeling an exposure a target according to said initial target design and measurement of said target for at least a plurality of different focus settings;
   varying the target design based on said modeling so as to improve said target design in terms of at least one performance indicator; and
   determining a final target design based on said at least one performance indicator.
2. A method as claimed in clause 1, comprising repeating a plurality of iterations of said modeling step and varying step before convergence on said final target design.
3. A method as claimed in clause 2, wherein said convergence is determined by said at least one performance indicator reaching at least one threshold value.
4. A method as claimed in any preceding clause, wherein said mask 3D effect comprises an asymmetric shadowing effect.
5. A method as claimed in any preceding clause, wherein either:
   more than 50% of target features comprised within the initial target design and/or final target design comprises horizontal features; and/or
   more than 50% of a target feature area of the initial target design and/or final target design is comprised of horizontal features.
6. A method as claimed in any preceding clause, wherein either:
   more than 60% of target features comprised within the initial target design and/or final target design comprises horizontal features; and/or
   more than 60% of a target feature area of the initial target design and/or final target design is comprised of horizontal features.
7. A method as claimed in any preceding clause, wherein either:
   more than 70% of target features comprised within the initial target design and/or final target design comprises horizontal features; and/or
   more than 70% of a target feature area of the initial target design and/or final target design is comprised of horizontal features.
8. A method as claimed in any preceding clause, wherein metrology tool optical-pitch features comprised within the initial target design and/or final target design comprise a line-space ratio denser than 1:2.
9. A method as claimed in any preceding clause, wherein metrology tool optical-pitch features comprised within the initial target design and/or final target design comprise a line-space ratio denser or equal to 1:1.
10. A method as claimed in any preceding clause, wherein metrology tool optical features comprised within the initial target design and/or final target design comprise a pitch to wavelength ratio of at least 1.05.
11. A method as claimed in any preceding clause, wherein said initial target design and/or final target design comprises at least a first sub-target and a second sub-target, said first sub-target and second sub-target comprising a respective different best focus value.
12. A method as claimed in any preceding clause, wherein said initial target design and/or final target design comprises a focus dependent asymmetry.
13. A method as claimed in any preceding clause, wherein said initial target design and/or final target design comprises only symmetric features, the initial target design and/or final target design comprising at least two sets of only symmetric features, each set having a different respective best focus value.
14. A method as claimed in any of clauses 1 to 12, wherein said initial target design and/or final target design comprises at least one asymmetric target feature, each asymmetric target feature comprising a combination of at least one metrology tool optical-pitch feature with at least one metrology tool below optical-pitch feature to form an asymmetric target feature.
15. A method as claimed in clause 14, wherein each said one or more metrology tool below optical-pitch features of each asymmetric target feature extends substantially perpendicularly from one side of a metrology tool resolvable feature of the asymmetric target feature.
16. A method as claimed in clause 14 or 15, wherein a line-space ratio of said metrology tool below optical-pitch features or sets of said metrology tool below optical-pitch features is less dense than 1:2.
17. A method as claimed in clause 14 or 15, wherein a line-space ratio of said metrology tool below optical-pitch features or sets of said metrology tool unresolvable features is less dense than 1:3.
18. A method as claimed in any of clauses 14 to 17, wherein said metrology tool below optical-pitch features are arranged in sets of fewer than four metrology tool below optical-pitch features.
19. A method as claimed in clause 18, wherein a line-space ratio of said metrology tool below optical-pitch features within each set is greater than 2:3.
20. A method as claimed in any of clauses 14 to 19, wherein said metrology tool below optical-pitch features each have a critical dimension and/or linewidth smaller than 30nm.
21. A method as claimed in any of clauses 14 to 19, wherein said metrology tool below optical-pitch features each have a critical dimension and/or linewidth smaller than smaller than 26nm.
22. A method as claimed in any of clauses 14 to 19, wherein said metrology tool below optical-pitch features each have a critical dimension and/or linewidth smaller than 20nm.
23. A method as claimed in any of clauses 20 to 22, wherein said metrology tool below optical-pitch features each have a below optical-pitch pitch smaller than or equal to twice the critical dimension and/or linewidth.
24. A method as claimed in any of clauses 14 to 23, wherein a length of the metrology tool below optical-pitch features is more than 3 times longer than the width of the metrology tool optical-pitch feature.
25. A method as claimed in any of clauses 14 to 23, wherein a length of the metrology tool below optical-pitch features is more than 5 times longer than the width of the metrology optical-pitch feature.
26. A method as claimed in any of clauses 14 to 25, wherein, for each asymmetric target feature, the metrology tool optical-pitch feature is vertical and the metrology tool below optical-pitch features are horizontal.
27. A method as claimed in any of clauses 14 to 26, wherein each asymmetric target feature comprises both a first metrology tool optical-pitch feature and a second metrology tool optical-pitch feature, the first metrology tool optical-pitch feature being oriented perpendicularly to the second metrology tool optical-pitch feature.
28. A method as claimed in any preceding clause, comprising applying optical proximity correction on the target design to increase focus sensitivity.
29. A method as claimed in clause 28, wherein said optical proximity correction is performed to only substantially enhance the dose process window of the target design, and not to substantially enhance the focus process window.
30. A method as claimed in clause 29, wherein said optical proximity correction is performed for a nominal focus value.
31. A method as claimed in any preceding clause, wherein said at least one performance indicator comprises a sensitivity of the metrology signal with focus.
32. A method as claimed in clause 31, wherein said at least one performance indicator additionally comprises one or more of: a strength of the metrology signal, a monotonicity and/or linearity of the sensitivity of the metrology signal with focus, a metrology signal range with respect to focus range, and/or focus-dose crosstalk.
33. A method as claimed in any preceding clause, wherein said modeling and varying steps are performed using a metrology target design platform comprising a computational lithography module which is able to simulate the lithography process of transferring the patterning device pattern onto a resist layer of a substrate and a computational metrology module able to simulate metrology operations on said patterning device pattern.
34. A method as claimed in any preceding clause, wherein said modeling step models a response of a metrology signal to at least focus for the target layout.
35. A method as claimed in any preceding clause, wherein said modelling step comprises also modelling non-focus aberration, wherein said performance indicator comprises sensitivity to focus with respect to sensitivity to non-focus aberration.
36. A method as claimed in clause 35, wherein said varying step comprises varying the target design to maximize or increasing sensitivity to focus while minimizing or reducing sensitivity to other aberration.
37. A method for designing a focus target for determining a focus setting of a lithographic apparatus used to form said target, the method comprising:
   modeling an exposure a target according to a target design and measurement of said target for at least a plurality of different focus settings;
   applying optical proximity correction on the target design to only substantially enhance a dose process window of the target design, and not to substantially enhance a focus process window;
   varying the target design based on said modeling so as to improve said target design in terms of at least one performance indicator; and
   determining a final target design based on said at least one performance indicator.
38. A method as claimed in any preceding clause, comprising:
   exposing a focus target on a substrate in accordance with said final focus target design.
39. A method as claimed in any preceding clause, comprising measuring said focus target to determine a focus setting at which said focus target was exposed.
40. A reflective reticle comprising focus target features arranged to pattern a radiation beam, said focus target features corresponding to said final focus target design as determined by the method of any preceding claim.
41. A substrate comprising at least one focus target corresponding to said final focus target design as determined by the method of any of clauses 1 to 39.
42. A computer program comprising program instructions operable to perform the method of any of clauses 1 to 39, when run on a suitable apparatus.
43. A non-transient computer program carrier comprising the computer program of clause 42.
44. A processing system comprising a processor and a storage device comprising the computer program of clause 42.
45. A lithographic apparatus comprising the processing system of clause 44.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may be made in this text to the focus metrology, it should be understood that the embodiments described herein may have other applications. Possible other applications include overlay metrology, dose metrology CD metrology, profilometry measurement, edge placement error (EPE) measurement, etc.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

It should be appreciated that the term color is used throughout this text synonymously with wavelength or spectral component and the colors may include those outside the visible band (e.g., infrared or ultraviolet wavelengths).

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method for designing a focus target for determining a focus setting of a lithographic apparatus used to form said target, the method comprising:
determining an initial target design, the initial target design being configure to enhance a mask 3D effect, resultant from the effect of three dimensional reticle features and an off-axis beam incidence on a reticle comprising target features arranged in accordance to said target design;
modeling an exposure a target according to said initial target design and measurement of said target for at least a plurality of different focus settings;
varying the target design based on said modeling so as to improve said target design in terms of at least one performance indicator; and
determining a final target design based on said at least one performance indicator.

2. A method as claimed in claim 1, comprising repeating a plurality of iterations of said modeling step and varying step before convergence on said final target design.

3. A method as claimed in any preceding claim, wherein either:
more than 50% of target features comprised within the initial target design and/or final target design comprises horizontal features; and/or
more than 50% of a target feature area of the initial target design and/or final target design is comprised of horizontal features.

4. A method as claimed in any preceding claim, wherein metrology tool optical-pitch features comprised within the initial target design and/or final target design comprise a line-space ratio denser than 1:2.

5. A method as claimed in any preceding claim, wherein metrology tool optical features comprised within the initial target design and/or final target design comprise a pitch to wavelength ratio of at least 1.05.

6. A method as claimed in any preceding claim, wherein said initial target design and/or final target design comprises at least a first sub-target and a second sub-target, said first sub-target and second sub-target comprising a respective different best focus value.

7. A method as claimed in any preceding claim, wherein said initial target design and/or final target design comprises only symmetric features, the initial target design and/or final target design comprising at least two sets of only symmetric features, each set having a different respective best focus value.

8. A method as claimed in any preceding claim, comprising applying optical proximity correction on the target design to increase focus sensitivity.

9. A method as claimed in any preceding claim, wherein said at least one performance indicator comprises a sensitivity of the metrology signal with focus.

10. A method as claimed in any preceding claim, wherein said modeling and varying steps are performed using a metrology target design platform comprising a computational lithography module which is able to simulate the lithography process of transferring the patterning device pattern onto a resist layer of a substrate and a computational metrology module able to simulate metrology operations on said patterning device pattern.

11. A method as claimed in any preceding claim, wherein said modeling step models a response of a metrology signal to at least focus for the target layout.

12. A method as claimed in any preceding claim, wherein said modelling step comprises also modelling non-focus aberration, wherein said performance indicator comprises sensitivity to focus with respect to sensitivity to non-focus aberration.

13. A reflective reticle comprising focus target features arranged to pattern a radiation beam, said focus target features corresponding to said final focus target design as determined by the method of any preceding claim.

14. A computer program comprising program instructions operable to perform the method of any of claims 1 to 13, when run on a suitable apparatus.

15. A processing system comprising a processor and a storage device comprising the computer program of claim 14.
